# DEMANDE DE BREVET EUROPEEN

(11) **EP 4 563 717 A1**
(43) Date de publication de la demande: **04.06.2025**
(21) Numéro de dépôt: 23213382.7
(22) Date de dépôt: 30.11.2023
(51) Int. Cl.: C23C 14/00, G04B 45/00, C23C 14/02, C23C 14/04, C23C 14/34, C23C 14/35, C23C 14/22

(54) **PROCÉDÉ DE DÉCORATION DE COMPOSANTS HORLOGERS**

(71) Demandeur: The Swatch Group Research and Development Ltd, 2074 Marin (CH)
(72) Inventeur: CURCHOD, Loïc, 1004 Lausanne (CH); SPASSOV, Vladislav, 1788 Praz (CH); SPRINGER, Simon, 3007 Berne (CH); WILLEMIN, Michel, 2515 Prêles (CH)
(74) Mandataire: ICB SA

(57) **Abrégé**

L'invention concerne un procédé de décoration d'un composant horloger comprenant les étapes suivantes :
a) préparation du composant horloger (1) ;
b) introduction du composant horloger dans un dispositif de dépôt sous vide, le dispositif de dépôt sous vide comprenant au moins une première source et une seconde source de matériaux à déposer ;
c) co-déposition simultanée ou successive d'au moins un premier matériau et un second matériau sur le composant horloger (1) pour former une couche de décoration avec un dégradé de couleurs (2).

Selon l'invention, l'une des sources est fixe et l'autre source est fixe ou mobile par rapport au composant horloger.

## Description

### Domaine technique de l'invention

L'invention relève du domaine des composants horlogers, et concerne un procédé de décoration de composants horlogers. Plus précisément, la présente invention se rapporte à un revêtement décoratif présentant un dégradé de couleurs obtenu par un dépôt physique sous vide en phase vapeur (PVD) tel que la pulvérisation cathodique.

### Arrière-plan technologique

L'industrie du domaine décoratif, et notamment l'horlogerie, est à la recherche de nouvelles solutions en termes de couleurs et d'apparence. Les articles horlogers présentant un dégradé de couleurs, tels que les cadrans, sont souvent obtenus par l'application de masques et d'une succession de dépôts de couches de couleurs sous forme de laque ou de vernis.

Les procédés de déposition physique, par exemple la pulvérisation cathodique, permettent d'obtenir des couches avec une apparence et des couleurs qui ne peuvent pas être réalisées avec des techniques de peinture ou émaillage conventionnelles. Ces couches sont également plus fines et présentent une grande durabilité, ce qui en permet l'emploi dans des éléments de petite taille ou sujets à l'usure. Cependant, les procédés de déposition physique sont conventionnellement utilisés pour le dépôt d'une couleur homogène.

Il existe donc un besoin de disposer de composants horlogers dont l'aspect présente un dégradé de couleurs obtenu par un procédé de dépôt physique sous vide, et ce de manière simple, rapide et à faible coût.

### Résumé de l'invention

L'invention a notamment pour objectif de pallier les différents inconvénients de l'art antérieur.

Plus précisément, un objectif de l'invention est de fournir un composant d'article d'horlogerie avec un dégradé de couleurs.

A cet effet, l'invention concerne un procédé de décoration d'un composant horloger comprenant les étapes suivantes :
a) préparation du composant horloger ;
b) introduction du composant horloger dans un dispositif de dépôt sous vide, le dispositif de dépôt sous vide comprenant au moins une première source et une seconde source de matériaux à déposer ;
c) co-déposition simultanée ou successive d'au moins un premier matériau et un second matériau sur le composant horloger pour former une couche de décoration avec un dégradé de couleurs.

Selon l'invention, l'une des sources est fixe et l'autre source est fixe ou mobile par rapport au composant horloger.

Conformément à d'autres variantes avantageuses de l'invention :
- les sources sont disposées à l'opposé l'une de l'autre dans la chambre à vide du dispositif de dépôt ;
- le premier matériau de la première source et le deuxième matériau de la deuxième source sont différents et sont choisis parmi un métal, ou un alliage métallique, ou un composé non-métallique ;
- le premier matériau et/ou le second matériau est un métal choisi parmi le titane, l'or, le cuivre, l'aluminium, l'argent, le platine, ou tout autre métal ou alliage métallique dont la déposition est maitrisée par l'homme du métier ;
- le premier matériau et/ou le second matériau est un composé non-métallique choisi parmi le silicium, ou les céramiques comme les oxydes ou nitrures ou oxy-nitrures de métaux, ou toute autre céramique dont la déposition est maitrisée par l'homme du métier ;
- le dispositif de dépôt comprend au moins un cache disposé entre une source et le substrat ;
- l'étape de préparation a) du substrat comprend un nettoyage par etching plasma in situ et/ou le dépôt d'une couche d'accroche ;
- le procédé comprend une étape finale d) de dépôt d'une couche de protection.

L'invention concerne aussi un composant horloger décoré au moyen d'un procédé de fabrication conforme à l'invention.

### Brève description des figures

D'autres caractéristiques et avantages de l'invention apparaîtront à la lecture de la description détaillée suivante donnée à titre d'exemple nullement limitatif, en référence aux dessins annexés dans lesquels :

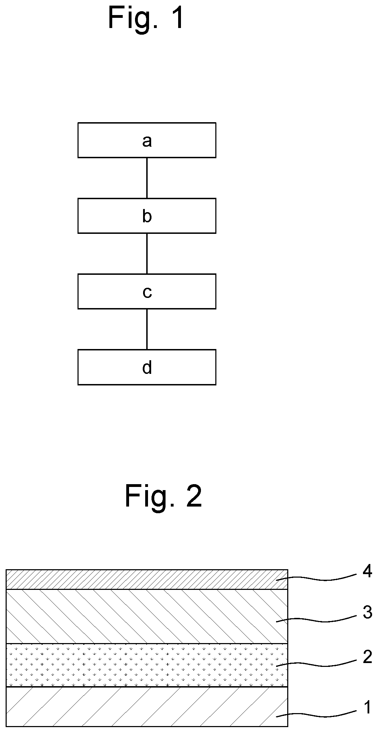

- la figure 1 représente schématiquement les étapes du procédé de fabrication de l'invention
- la figure 2 représente schématiquement une coupe d'un composant décoré au moyen du procédé de fabrication de l'invention.

### Description détaillée de l'invention

Selon un aspect de l'invention, la déposition des revêtements conférant un dégradé de couleurs à la surface du composant horloger est effectuée par un procédé PVD, notamment la pulvérisation cathodique à magnétron.

Une enceinte équipée d'un système de pulvérisation de type magnétron est utilisée dans le cadre de l'invention. Ledit système de pulvérisation comprend un arrangement d'aimants, des canaux de refroidissement, au moins deux cibles de pulvérisation, par exemple une première cible d'or et une seconde cible de cuivre, et des sources de tension pouvant porter les cibles ainsi que le porte-substrat à un potentiel électrique voulu. Le système de pulvérisation inclut également une installation à vide et des lignes d'injection de gaz permettant de réaliser, à l'intérieur de l'enceinte, une atmosphère contrôlée de type réactif ou inerte. Le fonctionnement d'un tel dispositif de pulvérisation est décrit dans la littérature scientifique et technique, et il ne sera répété ici que dans les grandes lignes.

La pulvérisation cathodique à magnétron consiste à pulvériser une cible constituée du matériau à déposer en couche mince. Après avoir créé du vide dans l'enceinte, un gaz inerte, tel que l'argon, y est introduit à faible pression. En appliquant une différence de potentiel entre la cible et l'enceinte, les atomes du gaz seront ionisés, et un plasma sera créé à l'intérieur de l'enceinte. La présence des aimants derrière la cible permet de confiner le plasma proche de cette dernière.

Les ions de gaz se dirigent vers la cible et bombardent celle-ci. Ceci provoque la pulvérisation des atomes de la cible qui se condensent sur les parois intérieures de l'enceinte, y compris sur le substrat. La pulvérisation s'effectuant en mode non-réactif (dans une atmosphère d'argon ou autre gaz inerte pur) résulte en un dépôt du matériau de la cible. Dans le cas où un gaz réactif est injecté dans l'enceinte pendant la pulvérisation, les atomes pulvérisés de la cible se combinent avec les atomes dudit gaz réactif et le dépôt sera un composé du matériau de la cible et du gaz réactif.

Le substrat est un composant horloger qui peut être choisi parmi les aiguilles, les appliques, les cadrans, les rehauts, les lunettes, les carrures, les bracelets, les fermoirs, les couronnes, les poussoirs, les masses oscillantes, les roues, les ponts, les platines, ou tout autre élément utilisé dans une pièce d'horlogerie auquel on souhaite donner une couleur.

Préférablement, le procédé de l'invention comporte une première étape de préparation du substrat ou composant horloger 1.

Le composant horloger 1 est tout d'abord préparé selon l'étape de préparation a) du procédé de l'invention. Cette étape de préparation peut comprendre, de manière optionnelle, une première étape de nettoyage in situ par attaque plasma (etching).

L'étape de préparation a) peut en outre comprendre, de manière optionnelle, une étape de dépôt d'un premier matériau sur le composant horloger 1 pour former une première sous-couche 2. De préférence, la première sous-couche 2 recouvre toutes les faces du composant horloger 1. Le dépôt de cette première sous-couche 2 est réalisé par le même procédé de dépôt PVD utilisé pour l'étape principale du dépôt décoratif.

Cette première sous-couche 2 permet de favoriser l'adhésion des autres couches à venir sur le composant horloger 1.

L'étape b) consiste à introduire le composant horloger 1 dans l'enceinte dont le dispositif de pulvérisation comprenant au moins deux sources de matériaux à déposer pour former la couche à dégradé de couleurs 3.

Le premier matériau de la première source et le deuxième matériau de la deuxième source sont choisis parmi un métal, ou un alliage métallique, ou un composé non-métallique.

Le premier matériau et/ou le second matériau est un métal choisi parmi le titane, l'or, le cuivre, l'aluminium, l'argent, le platine ou tout autre métal ou alliage métallique dont la déposition est maitrisée par l'homme du métier.

Le premier matériau et/ou le deuxième matériau est un composé non-métallique choisi parmi le silicium, ou les céramiques comme les oxydes ou nitrures ou oxy-nitrures de métaux, ou toute autre céramique dont la déposition est maitrisée par l'homme du métier.

L'étape suivante c), est l'étape de mise en couleur du composant horloger 1. Au cours de cette étape, les au moins deux cibles sont activées simultanément pour créer une couche de couleur sur le composant horloger. Lors du dépôt de cette couche, les au moins deux sources sont disposées autour du porte-substrats afin que les flux de matière provenant des cibles pulvérisées atteignent le substrat depuis des directions différentes et/ou avec des angles d'incidence différents, de sorte à former une couche avec un gradient en composition entre la matière de la première cible et la matière de la au moins une autre cible, résultant en un dégradé de couleurs à la surface du substrat.

Selon un autre mode de réalisation de l'invention, la première source reste fixe et la seconde source est mobile par rapport au composant horloger 1 pendant le dépôt, de manière à modifier son orientation par rapport au composant horloger et former le dégradé de couleurs souhaité.

Selon un autre mode de réalisation de l'invention, toutes les sources activées sont mobiles par rapport au composant horloger 1 pendant le dépôt, de manière à modifier leur orientation par rapport au composant horloger et former le dégradé de couleurs souhaité

Selon un autre mode de réalisation de l'invention, les première et seconde cibles sont activées successivement de manière que les flux des premier et second matériaux viennent successivement se déposer sur le composant horloger avec des directions d'incidence différentes et former un dégradé de couleurs. Lors des dépôts successifs de matériaux, les sources peuvent aussi être déplacées relativement au substrat pour créer un dégradé de couleurs spécifique.

Par exemple, lors de l'introduction du composant horloger dans l'enceinte, les deux sources sont disposées à l'opposé l'une de l'autre puis l'une d'elle est déplacée au cours du dépôt des matériaux. On peut également imaginer que les deux sources restent fixes.

Dans une variante de l'invention, le composant horloger 1 est déplacé par rapport à au moins l'une des sources pour former un dégradé de couleurs.

Encore selon une autre variante de l'invention, des caches de différentes géométries peuvent être placées au niveau des sources et/ou du substrat afin de favoriser le dépôt de la matière dans certaines zones du substrat.

La couche à dégradé de couleurs 3 ainsi déposée présente une épaisseur entre 100 nm et 2000 nm, de préférence entre 200 et 1000 nm, de préférence de 400 nm.

Une fois les matériaux déposés sur le composant horloger, le procédé peut comprendre une dernière étape d) au cours de laquelle une couche mince de protection transparente 4 est déposée dans la même ou une autre enceinte, par un procédé PVD, ou un procédé ALD, ou tout autre procédé maîtrisé par l'homme du métier.

Selon une variante avantageuse de l'invention, l'épaisseur et la composition de la couche mince de protection 4 peuvent être choisies de sorte à modifier les couleurs de la couche à dégradé de couleur 3 par effet interférentiel, de sorte à obtenir de nouvelles couleurs et/ou un effet esthétique avantageux.

Le procédé de l'invention permet de déposer un dégradé de couleurs sur divers composants horlogers afin d'obtenir des composants horlogers particulièrement attrayants. On peut par exemple déposer le dégradé de couleurs sur des composants d'habillage interne tels que cadrans, aiguilles, appliques, ponts, platines, barillets. Le procédé de l'invention peut être appliqué également à d'autres articles décoratifs, par exemple des composants d'habillage externe tels que carrures ou lunettes.

## Revendications

1. Procédé de décoration d'un composant horloger (1) comprenant les étapes suivantes :
a) préparation du composant horloger (1) ;
b) introduction du composant horloger (1) dans un dispositif de dépôt sous vide, le dispositif de dépôt sous vide comprenant au moins une première source et une seconde source de matériaux à déposer ;
c) co-déposition simultanée ou successive d'au moins un premier matériau et un second matériau sur le composant horloger (1) pour former une couche de décoration avec un dégradé de couleurs (3),
**caractérisé en ce que** l'une des sources est fixe et l'autre source est fixe ou mobile par rapport au composant horloger (1).

2. Procédé de décoration selon la revendication 1, **caractérisé en ce que** les sources sont disposées à l'opposé l'une de l'autre dans la chambre à vide du dispositif de dépôt.

3. Procédé de décoration selon la revendication 1 ou 2, **caractérisé en ce que** le premier matériau de la première source et le deuxième matériau de la deuxième source sont différents et sont choisis parmi un métal ou un alliage métallique, ou un composé non-métallique.

4. Procédé de décoration selon la revendication 3, dans lequel le premier matériau et/ou le second matériau est un métal choisi parmi le titane, l'or, le cuivre, l'aluminium, l'argent, le platine, ou tout autre métal ou alliage métallique.

5. Procédé de décoration selon l'une des revendications 1 à 4, dans lequel le premier matériau et/ou le deuxième matériau est un composé non-métallique choisi parmi le silicium ou les céramiques comme les oxydes ou nitrures ou oxy-nitrures de métaux, ou toute autre céramique.

6. Procédé de décoration selon l'une des revendications 1 à 5, dans lequel le dispositif de dépôt comprend au moins un cache disposé entre une source et le substrat.

7. Procédé de décoration selon l'une des revendications 1 à 6, dans lequel l'étape de préparation a) du substrat comprend un nettoyage par etching plasma in situ et/ou le dépôt d'une couche d'accroche (2).

8. Procédé de décoration selon l'une des revendications 1 à 7, **caractérisé en ce qu'**il comprend une étape finale d) de dépôt d'une couche de protection transparente (4).
